# EUROPÄISCHE PATENTANMELDUNG

(11) **EP 2 043 421 A2**
(43) Veröffentlichungstag der Anmeldung: **01.04.2009**
(21) Anmeldenummer: 08105058.5
(22) Anmeldetag: 18.08.2008
(51) Int. Cl.: H05K 13/08, H05K 13/02

(54) **Instandhaltung einer auswechselbaren Komponente einer Bestückvorrichtung**

(30) Priorität: 27.09.2007 DE 102007046346
(71) Anmelder: Siemens Aktiengesellschaft, 80333 München (DE)
(72) Erfinder: Rall, Andreas, 82418, Murnau (DE)

(57) **Zusammenfassung**

Es wird ein Verfahren zum Instandhalten einer auswechselbaren Komponente (120) einer Bestückvorrichtung zum automatischen Bestücken von Bauelementeträgern mit elektronischen Bauelementen beschrieben. Das Verfahren weist auf ein Ermitteln von zumindest einer Information über den technischen Zustand der auswechselbaren Komponente (120), ein Identifizieren eines Fehlers der auswechselbaren Komponente (120) basierend auf der zumindest einen ermittelten Information, und ein Extrahieren von zumindest einer spezifischen Maßnahme zum Instandhalten der auswechselbaren Komponente (120) basierend auf dem Fehler aus einer Datenbank (148), in welcher mehrere verschiedene spezifische Maßnahmen gespeichert sind, wobei jedem Fehler eindeutig zumindest eine spezifische Maßnahme zugeordnet ist. Es wird ferner ein Messsystem und eine Messstation (100) für eine Instandhaltung von auswechselbaren Komponenten einer Bestückvorrichtung beschrieben, mit denen das oben genannte Instandhaltungsverfahren durchführbar ist.

## Beschreibung

Die vorliegende Erfindung betrifft das technische Gebiet der automatischen Bestückung von Bauelementeträgern mit elektronischen Bauelementen mittels Bestückautomaten. Die vorliegende Erfindung betrifft insbesondere ein Verfahren, ein Messsystem und eine Messstation für eine Instandhaltung von auswechselbaren Komponenten einer Bestückvorrichtung. Außerdem betrifft die vorliegende Erfindung ein computerlesbares Speichermedium sowie ein Programm-Element, welche Instruktionen zur Durchführung des erfindungsgemäßen Verfahrens zum Instandhalten einer auswechselbaren Komponente einer Bestückvorrichtung aufweisen.

Um den steigenden Anforderungen an die Zuverlässigkeit und an die Genauigkeit von Bestückungsprozessen insbesondere von oberflächenmontierbaren Bauelementen gerecht zu werden, ist es erforderlich, dass alle Komponenten einer Bestückvorrichtung, welche zu dem Bestückungsprozess beitragen, hohe Qualitätsanforderungen erfüllen. Die Genauigkeit von vielen Bestückvorrichtungen wird dabei vor allem durch die Genauigkeit eines Flächen-Positioniersystems bestimmt, mit dem ein Bestückkopf, welcher ein oder mehrere Bauelemente aufnehmen kann, zwischen einer Abholposition für die aufzunehmenden elektronischen Bauelemente und einer Bestückposition für die auf einen zu bestückenden Bauelementeträger aufzusetzenden elektronischen Bauelemente verfahren wird.

Ferner ist für einen genauen und insbesondere für einen zuverlässigen Bestückbetrieb mit einer hohen Prozesssicherheit auch eine hochgenaue Bereitstellung der elektronischen Bauelemente an den vorgesehenen Bauelement-Abholpositionen erforderlich. Diese Bereitstellung erfolgt üblicherweise mittels sog. Bauelement-Zuführvorrichtungen, welche beispielsweise in einem Gurt verpackte Bauelemente mittels eines Transportrades, welches in Eingriff mit einer Perforation des Gurtes steht, hin zu der vorgesehenen Abholposition transportieren. An der Abholposition kann das jeweilige Bauelement dann von einem Bestückkopf aus einer Tasche des Bauelement-Gurtes entnommen werden.

Bestückkopf und insbesondere die Zuführvorrichtungen sind auswechselbare Komponenten einer Bestückvorrichtung. Diese Komponenten verlieren im Laufe ihres Betriebes ihre zugesicherten Eigenschaften. Diese Eigenschaften sind beispielsweise bei einer Bauelement-Zuführvorrichtung die Genauigkeit der Bauelement-Bereitstellung, die Zuführgeschwindigkeit, die verfügbaren Zugkräfte für den Gurt und/oder für ein Abziehen einer den Gurt bedeckenden Abdeckfolie.

Wenn die Parameter, mit denen diese Eigenschaften in geeigneter Weise beschreiben werden, Werte außerhalb von zulässigen Bereichen annehmen, dann verringert sich dadurch die Prozessfähigkeit der gesamten Bestückvorrichtung. Deshalb müssen die auswechselbaren Komponenten von Zeit zu Zeit einer Überprüfung bzw. einer Wartung unterzogen werden. Nur so kann eine qualitativ hochwertige Bestückung von Bauelementeträgern mit elektronischen Bauelementen gewährleistet werden. Außerdem können durch eine regelmäßige Überprüfung bzw. Wartung ungeplante Stillstandszeiten einer Bestückvorrichtung oder gar ganze Produktionsstillstände vermieden werden.

In der Praxis ist jedoch die Qualität der Wartung und einer ggf. erforderlichen Instandsetzung der betroffenen auswechselbaren Komponenten stark vom Wissensstand und der Sorgfalt einer die Wartung bzw. die Instandsetzung durchführenden Bedienperson abhängig. Eine einigermaßen gleichbleibend hohe Qualität bei der Wartung bzw. bei der Instandsetzung von auswechselbaren Komponenten wird in der Realität daher regelmäßig nicht erreicht.

Der Erfindung liegt die Aufgabe zugrunde, die Instandhaltung einer auswechselbaren Komponente einer Bestückvorrichtung zu verbessern.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Verfahren zum Instandhalten einer auswechselbaren Komponente einer Bestückvorrichtung zum automatischen Bestücken von Bauelementeträgern mit elektronischen Bauelementen beschrieben. Das beschriebene Verfahren weist auf (a) ein Ermitteln von zumindest einer Information über den technischen Zustand der auswechselbaren Komponente, (b) ein Identifizieren eines Fehlers der auswechselbaren Komponente basierend auf der zumindest einen ermittelten Information, und (c) ein Extrahieren von zumindest einer spezifischen Maßnahme zum Instandhalten der auswechselbaren Komponente basierend auf dem Fehler aus einer Datenbank, in welcher mehrere verschiedene spezifische Maßnahmen gespeichert sind, wobei jedem Fehler eindeutig zumindest eine spezifische Maßnahme zugeordnet ist.

Der vorliegenden Erfindung liegt die Erkenntnis zugrunde, dass durch die Verwendung einer entsprechend umfangreichen Datenbank eine systematische Diagnose der Eigenschaften der auswechselbaren Komponente durchgeführt und definierte Maßnahmen zur Instandhaltung der auswechselbaren Komponente angegeben werden können. In der Datenbank sind dabei bevorzugt möglichst viele verschiedene Fehler gespeichert, die im Laufe eines Lebens bzw. innerhalb der Lebensdauer der auswechselbaren Komponente auftreten können. In der Datenbank sind ferner für jeden oder zumindest für mehrere Fehler konkrete Arbeitsinhalte hinterlegt, die für eine Bedienperson konkrete Anweisungen zur Instandhaltung darstellen.

Anschaulich gesprochen bedeutet dies, dass bei dem beschriebenen Instandhaltungsverfahren die ermittelten Information über den technischen Zustand der auswechselbaren Komponente ausgewertet und jeweils ein geeignetes vorab festgelegten Ablaufschema zur Instandhaltung der auswechselbaren Komponente ausgegeben wird.

Abhängig von dem jeweiligen Typ der auswechselbaren Komponente können verschiedene Ablaufschemata ausgegeben werden. Dies bedeutet, dass (a) bei einem bestimmten Fehler bei einem ersten Typ von auswechselbarer Komponente ein erstes Ablaufschema und (b) bei demselben Fehler bei einem zweiten Typ von auswechselbarer Komponente ein zweites Ablaufschema ausgegeben werden kann, welches sich von dem ersten Ablaufschema unterscheidet.

Es wird darauf hingewiesen, dass im Rahmen dieser Anmeldung der Begriff Instandhalten sowohl Reparatur- als auch Wartungsarbeiten umfassen kann. Entsprechend ist unter dem Begriff Fehler nicht zwangsläufig zu verstehen, dass bereits ein Ausfall der auswechselbaren Komponente vorliegt. Unter dem Begriff Fehler ist demzufolge auch zu verstehen, dass sich ein Parameter der auswechselbaren Komponente außerhalb oder am Rand eines vorgegebenen für einen zuverlässigen Betrieb der auswechselbaren Komponente zulässigen bzw. vorgesehenen Wertebereichs befindet.

Die auswechselbare Komponente kann prinzipiell jede mobile Komponente einer Bestückvorrichtung bzw. einer ganzen Bestücklinie sein, welche von einer Bedienperson mit einem mehr oder weniger großen Aufwand ausgebaut werden kann. Zum Zwecke eines möglichst durchgehenden Betriebs der Bestückvorrichtung bzw. der Bestücklinie kann die auswechselbare Komponente durch eine andere auswechselbare Komponente ausgetauscht werden.

Die auswechselbare Komponente kann insbesondere eine Zuführeinheit zum Zuführen von beispielsweise in bekannter Weise in Gurten verpackten elektronischen Bauelementen an eine vorgegebene Abholposition eines Bestückautomaten sein. Die auswechselbare Komponente kann jedoch auch beispielsweise ein Bestückkopf, eine Wechselvorrichtung für Bauelement-Flächenmagazine oder ein sog. Dip-Modul sein, mit dem automatisch eine zähe Flüssigkeit (z.B. ein Underfill-Material oder ein Klebstoff) auf ein zu bestückendes Bauelement oder auf einen Bauelement-Einbauplatz eines Bauelementeträgers aufgebracht werden kann.

Das beschriebene Verfahren hat den Vorteil, dass Instandhaltungsmaßnahmen auf einfache und effiziente Weise standardisiert werden könne. Durch das Vorgeben von fest vorgeschriebenen Arbeitsabläufen hängt auf vorteilhafte Weise die Qualität von vorgenommenen Instandhaltungsarbeiten nur noch im geringen Umfang von der Geschicklichkeit und/oder der Gründlichkeit der ausführenden Bedienperson ab.

Gemäß einem Ausführungsbeispiel der Erfindung wird die zumindest eine Information durch Auslesen von Daten aus einem der auswechselbaren Komponente zugeordneten Datenspeicher ermittelt. Dies hat den Vorteil, dass zur Identifizierung des Fehlers bzw. zur Fehlerdiagnose auf eine Vielzahl von Daten zurückgegriffen werden kann, die bereits während des gewöhnlichen Betriebs der auswechselbaren Komponente gesammelt wurden.

Die gesammelten Daten können dabei einfach in dem Datenspeicher der auswechselbaren Komponente von einer zentralen Steuereinheit der Bestückvorrichtung hinterlegt werden. Die auswechselbare Komponente kann jedoch auch einen eigenen Prozessor aufweisen, der von der Steuereinheit der Bestückvorrichtung übermittelte oder von entsprechenden Messeinheiten der auswechselbaren Komponente bereitgestellte Daten auswertet und in geeigneter Weise und/oder in einem geeigneten Datenformat in dem Datenspeicher hinterlegt.

So können beispielsweise von der auswechselbaren Komponente vorgegebene Arbeitszyklen der auswechselbaren Komponente gezählt werden, so dass die bisherige Arbeitsleistung der auswechselbaren Komponente bei der Fehlerdiagnose und/oder bei der Auswahl von geeigneten Maßnahmen zur Instandhaltung der auswechselbaren Komponente in geeigneter Weise berücksichtigt werden kann. Die Berücksichtigung der vollbrachten Arbeitszyklen kann auch für die Bestimmung einer Ausfallsprognose und/oder für eine geeignete Bestimmung der Wartungsintervalle der auswechselbaren Komponente verwendet werden. Dies bedeutet, dass das beschriebene Instandhaltungsverfahren in wiederholten Abständen durchgeführt wird. Der Wartungsabstand kann jedoch nicht nur von der Anzahl an vollbrachten Arbeitszyklen sondern auch einfach durch einen gewissen Zeitablauf gegeben sein.

Gemäß einem weiteren Ausführungsbeispiel der Erfindung wird die zumindest eine Information durch zumindest eine spezifische Messung an der auswechselbaren Komponente ermittelt.

Während der spezifischen Messung befindet sich die auswechselbare Komponente bevorzugt in einem ausgebauten Zustand. Dies bedeutet, dass die auswechselbare Komponente von einer Bestückvorrichtung abgebaut wurde, so dass unabhängig von einem ggf. laufenden Bestückbetrieb der Bestückvorrichtung die Vermessung der auswechselbaren Komponente durchgeführt werden kann.

Bevorzugt kann die Vermessung der auswechselbaren Komponente in einer definierten Messstation erfolgen, welche geeignete Untersuchungsmittel aufweist wie beispielsweise eine Kamera oder elektrische Mess- und Testeinrichtungen zum Bestimmen von elektrischen Parametern wie beispielsweise eine Motorleistung, ein Isolationswiderstand oder sonstige Widerstände, welche der auswechselbaren Komponente zugeordnet werden können. Die Messstation kann auch eine geeignete Schnittstelle aufweisen, über die Daten aus einem o. g. der auswechselbaren Komponente zugeordneten Datenspeicher ausgelesen werden können.

Gemäß einem weiteren Ausführungsbeispiel der Erfindung weist die zumindest eine spezifische Messung auf (a) einen Funktionstest eines beweglichen Bauteils der auswechselbaren Komponente mittels einer Lichtschranke, (b) eine Positionsüberprüfung von zumindest einem Bauteil der auswechselbaren Komponente mittels einer Kamera und einer der Kamera nach geschalteten Bildauswertung, (c) eine Überprüfung der Motorleistung eines Motors der auswechselbaren Komponente, (d) eine Messung eines Isolationswiderstandes und/oder (e) eine Messung der Stromwerte der auswechselbaren Komponente und/oder eine Messung von Stromwerten von zumindest einem Bauteil der auswechselbaren Komponente.

Der beschriebene Funktionstest mittels einer Lichtschranke kann insbesondere dann für die Identifizierung eines Fehlers verwendet werden, wenn es sich bei der auswechselbaren Komponente um eine bekannte Bauelement-Zuführvorrichtung handelt. Eine Bauelement-Zuführvorrichtung weist nämlich als besonders empfindliches und fehleranfälliges Bauteil eine sogenannte Folienabzugsschwinge auf. Diese dient dazu, eine Deckfolie, welche im geschlossenen Zustand ein Herausfallen von elektronischen Bauelementen aus einem Bauelementgurt verhindert, unter einer stets geeigneten Zugspannung unmittelbar vor einer Bauelemententnahme aus dem Gurt, abzuziehen, so dass die Bauelemente von einem Bestückkopf in bekannter Weise abgeholt werden können.

Bei einer Überprüfung der Motorleistung einer Bauelement-Zuführvorrichtung kann auf vorteilhafte Weise Gurtmaterial verwendet werden, welches eine volle oder lediglich teilweise entleerte Gurtrolle simuliert und welches an einem Ende einer Federwaage anzieht, deren anderes Ende an einem festen Befestigungspunkt angebracht ist. Sofern die gemessene Kraft einen vorgegebenen Mindestwert erreicht hat, dann kann über ein Signal das positive Ergebnis der Motorleistungsmessung mitgeteilt werden.

Bei der Messung des Isolationswiderstandes können alle möglichen elektrischen Leiterbahnen einer Platine oder elektrisch leitende Adern einer Stromzuführung gegen Erde gemessen werden. So kann beispielsweise schnell und zuverlässig erkannt werden, ob bei der Montage der auswechselbaren Komponente ein Kabel eingeklemmt wurde oder ob ein Motor der auswechselbaren Komponente einen Masseschluss aufweist.

Gemäß einem weiteren Ausführungsbeispiel der Erfindung weist das Verfahren zusätzlich auf ein Ermitteln von zumindest einem Prozessfähigkeitskennwert für die auswechselbare Komponente basierend auf einem Ergebnis der zumindest einen spezifischen Messung.

So können beispielsweise mittels einer Kamera Einzelbilder der Zähne eines Zahnrades aufgenommen und mittels einer geeigneten Bilderkennungssoftware die genaue räumliche Lage der Mittelpunkte bzw. der Mittelachsen der Zähne bestimmt werden. Eine räumliche Verschiebung der Mittelpunkte bzw. der Mittelachsen der Zähne ist beispielsweise bei einem Transportzahnrad bzw. einem Stiftrad einer Bauelement-Zuführvorrichtung ein wichtiger Hinweis auf den Grad des Verschleißes eines Transportzahnrades, mit dem ein Gurt in Richtung einer Bauelement-Abholposition geschoben wird. Bei einem derartigen Transport befinden sich in bekannter Weise einzelne Zähne des Transportzahnrades mit einer Transportperforation an dem Bauelementgurt in Eingriff.

Die beschriebene direkte Vermessung des Verschleißes des Transportzahnrades durch eine direkte Beurteilung der Form der einzelnen Zähne hat gegenüber einer bekannten Methode zur Bestimmung der Transportgenauigkeit mittels eines Federstahlbandes mit aufgebrachten feinen Markierungen den Vorteil, dass die Transportgenauigkeit und damit die räumliche Präzision, mit der elektronische Bauelemente an der Abholposition der Bauelement-Zuführvorrichtung bereitgestellt werden, wesentlich genauer bestimmt werden kann.

Es wird darauf hingewiesen, dass die zu erwartende Transportgenauigkeit auch durch eine optische Vermessung der genauen Positionen der Zähne bzw. der Stifte des Transportrades relativ zu einer Referenzmarkierung erfolgen kann, welche auch zur Vermessung der Genauigkeit von der Bereitstellung von elektronischen Bauelementen an der Bauelement-Abholposition verwendet wird und welche deshalb in unmittelbarer Nähe der Bauelement-Abholposition angebracht ist. Die Referenzmarkierung kann beispielsweise eine sog. Teach-Markierung sein, welche üblicherweise für einen Lernprozess einer Zuführvorrichtung im Hinblick auf eine möglichst exakte Bauelement-Bereitstellung an der Bauelement-Abholposition verwendet wird. Im Vergleich zu einer bekannten Messung der Genauigkeit der Bereitstellung von elektronischen Bauelementen relativ zu einer Kontur an der Rückseite der Bauelement-Zuführvorrichtung, über welche Kontur die Zuführvorrichtung an einem Gehäuse befestigt wird, liefert die Vermessung relativ zu der Referenz- bzw. Teach-Markierung deutlich genauere Messwerte bzgl. der Genauigkeit der Bauelement-Bereitstellung.

Basierend auf den ermittelten durch Verschleiß bewirkten Abweichungen kann somit eine Aussage darüber getroffen werden, ob die untersuchte Bauelement-Zuführvorrichtung noch gut genug für die ggf. sehr strengen Qualitätsanforderungen für eine Bestückung ist oder ob ggf. das Transportrad der Bauelement-Zuführvorrichtung ausgetauscht werden muss. Ferner können zur Bestimmung von Prozessfähigkeitskennwerten bekannte statistische Methoden zur Klassifizierung der sog. Maschinenfähigkeit herangezogen werden. Dabei kann beispielsweise der sog. Cmk-Wert ausgerechnet werden, welcher eine Aussage darüber liefert, wo der Mittelwert einer vermessenen Stichprobe im Vergleich zu einer vorgegebenen Toleranz liegt. Der Cmk-Wert kann dabei als zuverlässige Aussage darüber verwendet werden, ob eine bestimmte auswechselbare Komponente noch gut genug ist, um für die Produktion von elektronischen Baugruppen bzw. für eine Bestückung von Bauelementeträgern verwendet zu werden.

Gemäß einem weiteren Ausführungsbeispiel der Erfindung weist das Verfahren zusätzlich auf ein Bestimmen von zukünftig zu erwartenden Fehlern bezüglich des technischen Zustandes der auswechselbaren Komponente basierend auf der zumindest einen ermittelten Information.

Anschaulich gesprochen bedeutet dies, dass aktuell ermittelte Prüfdaten und Prüfergebnisse und die darin enthaltene Fehlerinformation für Ausfallprognosen der auswechselbaren Komponenten und für zukünftig erforderliche Wartungs- und Instandhaltungsmaßnahmen für die auswechselbare Komponente herangezogen werden können. Durch eine umfassende Auswertung von möglichen Ausfallsgründen, von zu erwartenden Lebensdauern und/oder von einem zu erwartenden Verbrauch an Ersatzteilen kann ein umfassendes Management sowohl hinsichtlich der in der Zukunft voraussichtlich zu leistenden Arbeitsstunden für die Instandhaltung der auswechselbaren Komponente als für eine entsprechende Lagerhaltung an Ersatzteilen realisiert werden.

Gemäß einem weiteren Ausführungsbeispiel der Erfindung weist das Verfahren zusätzlich auf (a) ein Verwenden einer eindeutigen Identitätsinformation für die auswechselbare Komponente und (b) ein Aufzeichnen der ermittelten Informationen über den technischen Zustand der auswechselbaren Komponente zusammen mit der eindeutigen Identitätsinformation.

Die eindeutige Identitätsinformation kann dabei jedes Mal dann erfasst werden, wenn das beschriebene Instandhaltungsverfahren durchgeführt wird. Sollte eine auswechselbare Komponente noch keine eindeutige Identitätsinformation erhalten haben, dann kann dieser Umstand auf einfache Weise erkannt und eine derartige eindeutige Identitätsinformation erzeugt werden. Als Identitätsinformation kann beispielsweise ein alphanumerischer Code, ein Strichcode, ein Matrixcode oder ein Transponder verwendet werden, welcher an einer geeigneten Stelle an der auswechselbaren Komponente angebracht werden kann. Ggf. kann die Identitätsinformation beispielsweise durch einen geeigneten Markierungsdrucker hergestellt und als Aufkleber an der auswechselbaren Komponente angebracht werden.

Die Verwendung einer beschriebenen Identitätsinformation für jede auswechselbare Komponente bedeutet, dass durch eine eindeutige Serialisierung der aktuelle technische Zustand von einer Vielzahl von auswechselbaren Komponenten überwacht und der Aufwand für Instandhaltung und Unstandsetzung relativ genau abgeschätzt werden kann.

Durch ein Aufzeichnen bzw. Abspeichern der ermittelten Informationen jeweils für eine bestimmte auswechselbare Komponente wird somit automatisch eine Historie für die auswechselbare Komponente gespeichert, in der sämtliche im Laufe eines Produktlebenszyklus ermittelte Informationen enthalten sein können. Damit können dann geeignete Ableitungen bzw. Schlussfolgerungen beispielsweise bzgl. der Effizient der jeweiligen auswechselbaren Komponente gemacht werden. So können beispielsweise wertvolle Hilfestellungen zu folgenden interessanten Fragestellungen gegeben werden:
- Wie oft wurde die jeweilige auswechselbare Komponente repariert oder gewartet?
- Wie alt ist die betreffende auswechselbare Komponente?
- Wann sollte die betreffende auswechselbare Komponente ausgetauscht werden?
- Welche Kosten sind bisher für Instandhaltungs- und/oder Instandsetzungsarbeiten für diese auswechselbare Komponente aufgelaufen?
- Rentiert sich eine Reparatur der auswechselbaren Komponente aus wirtschaftlichen Gesichtspunkten?
Außerdem können aus der Historie, wie oben bereits angedeutet, Daten bzgl. zu erwartender zukünftiger Ausfallzeiten, Ersatzteilverbrauche oder Kapazitätsbedarfe für Wartungsaufgaben abgeleitet werden.

Die Verwendung einer eindeutigen Identitätsinformation ist insbesondere dann vorteilhaft, wenn es sich bei der bzw. bei den auswechselbaren Komponenten um Bauelement-Zuführvorrichtungen handelt. Bauelement-Zuführvorrichtungen werden nämlich in der Praxis je nach Bedarf innerhalb einer ganzen Fabrik, in der eine Vielzahl von Bestückvorrichtungen in Betrieb sein können, immer dort eingesetzt, wo sie gerade gebraucht werden. Die beschriebene eindeutige Identitätsinformation macht es daher auf vergleichsweise einfache Weise möglich, einen genauen Überblick über die Anzahl und den Zustand der in einer Fabrik verwendeten Zuführvorrichtungen zu behalten.

Gemäß einem weiteren Ausführungsbeispiel der Erfindung weist das Verfahren zusätzlich auf (a) ein Anweisen einer Bedienperson zum Durchführen der zumindest einen spezifischen Maßnahme zum Instandhalten der auswechselbaren Komponente und (b) ein Überprüfen, ob die zumindest eine spezifische Maßnahme auch tatsächlich ausgeführt wurde. Dies bedeutet, dass nach einem Abschluss des beschriebenen Instandhaltungsverfahrens überprüft wird, ob alle erforderlichen Pflichtschritte des vorgesehenen Wartungs- und/oder Reparaturdurchlaufs auch korrekt durchgeführt wurden. Auf diese Weise kann die Prozesssicherheit von Wartungs- und/oder Reparaturarbeiten erheblich verbessert werden, da ein Reihe von in der Praxis häufig vorkommenden Fehlern zuverlässig vermieden werden können.

Durch die beschriebene Überprüfung der ausgeführten Instandhaltungsmaßnahmen entsteht auf vorteilhafte Weise ein weitgehend automatisierter, systematischer und sehr robuster Regelkreis für eine Instandhaltung bzw. Instandsetzung von allen möglichen auswechselbaren Komponenten, die im Rahmen der Bestücktechnik in mehr oder weniger regelmäßigen Abständen gewartet und ggf. repariert werden müssen.

Gemäß einem weiteren Aspekt der Erfindung wird ein Messsystem für eine auswechselbare Komponente einer Bestückvorrichtung zum automatischen Bestücken von Bauelementeträgern mit elektronischen Bauelementen beschrieben. Das beschriebene Messsystem weist auf (a) eine Messstation zum Aufnehmen der auswechselbaren Komponente und zum Ermitteln von zumindest einer Information über den technischen Zustand der auswechselbaren Komponente, und (b) eine Datenverarbeitungseinrichtung, welche über eine Schnittstelle, die zum Übertragen der zumindest einen ermittelten Information eingerichtet ist, mit der Messstation gekoppelt ist. Die Datenverarbeitungseinrichtung ist derart eingerichtet, dass basierend auf der zumindest einen ermittelten Information ein Fehler der auswechselbaren Komponente identifizierbar ist und dass basierend auf dem Fehler aus einer Datenbank zumindest eine spezifische Maßnahme zum Instandhalten der auswechselbaren Komponente extrahiert wird. Dabei sind in der Datenbank mehrere verschiedene spezifische Maßnahmen gespeichert und jedem Fehler ist eindeutig eine spezifische Maßnahme zugeordnet.

Dem beschriebenen Messsystem liegt die Erkenntnis zugrunde, dass durch die Verwendung einer entsprechend umfangreichen Datenbank eine systematische Diagnose der Eigenschaften der auswechselbaren Komponente durchgeführt und definierte Maßnahmen zur Instandhaltung der auswechselbaren Komponente angegeben werden können. Mit dem Messsystem, welches abgesehen von einer speziell ausgebildeten Messstation lediglich einen handelsüblichen Computer mit einer geeigneten Software benötigt, kann das oben beschriebene Instandhaltungsverfahren durchgeführt und dabei sämtliche oben beschriebenen Vorteile realisiert werden.

Die Datenbank kann ein Speicher der Datenverarbeitungseinrichtung sein. Alternativ kann die Datenverarbeitungseinrichtung in bekannter Weise beispielsweise über ein Netzwerk mit einer externen Datenbank verbunden sein, in der die entsprechenden Informationen gespeichert sind.

Gemäß einem weiteren Aspekt der Erfindung wird eine Messstation für eine auswechselbare Komponente einer Bestückvorrichtung zum automatischen Bestücken von Bauelementeträgern mit elektronischen Bauelementen beschrieben. Die Messstation weist auf (a) eine Einrichtung zum Aufnehmen der auswechselbaren Komponente, (b) eine Einrichtung zum Ermitteln von zumindest einer Information über den technischen Zustand der auswechselbaren Komponente und (c) eine Schnittstelle zum Anschließen der Messstation an eine Datenverarbeitungseinrichtung, wobei die Schnittstelle derart eingerichtet ist, dass die zumindest eine Information über den technischen Zustand der auswechselbaren Komponente an die Datenverarbeitungseinrichtung transferierbar ist. Ferner ist die Messstation derart eingerichtet, dass in Verbindung mit der Datenverarbeitungsvorrichtung das oben beschriebene Instandhaltungsverfahren ausführbar ist.

Der beschriebenen Messstation liegt die Erkenntnis zugrunde, dass durch ein definiertes Aufnehmen der auswechselbaren Komponente die Information über den technischen Zustand der auswechselbaren Komponente auf besonders zuverlässige Weise ermittelt werden kann. Diese Information kann nachfolgend an die Datenverarbeitungseinrichtung zum Zwecke der weiteren Datenverarbeitung transferiert werden. Bei der Datenverarbeitung wird dann zumindest eine spezifische Maßnahme zur Instandhaltung der auswechselbaren Komponente aus einer Datenbank extrahiert.

Anschaulich betrachtet stellt die Messstation ein Art "Docking-Station" dar, an welcher die auswechselbare Komponente angeschlossen werden kann. Bevorzugt kann die auswechselbare Komponente in der Messstation einen typischen Arbeitsablauf mit definierten Arbeitsparametern simulieren, so dass das Verhalten der auswechselbaren Komponente unter möglichst realistischen Arbeitsbedingungen getestet werden kann.

Die Schnittstelle kann beispielsweise eine bekannte standardisierte Universal Serial Bus (USB) Schnittstelle sein. Dies hat den Vorteil, dass die Messstation an einen handelsüblichen Computer angeschlossen werden kann, so dass zum Betrieb der Messstation lediglich eine geeignete Software auf dem handelsüblichen Computer installiert werden muss.

Gemäß einem Ausführungsbeispiel der Erfindung weist die Messstation zusätzlich eine Einrichtung zum Identifizieren der auswechselbaren Komponente auf. Mit der beschriebenen Identifikationsvorrichtung, welche beispielsweise ein Strichcode-Scanner oder ein RFID Lesegerät sein kann, kann entweder eine Identifikation lediglich des Typs der auswechselbaren Komponente oder zusätzlich eine eindeutige Identifikation der auswechselbaren Komponente vorgenommen werden, welche bei der Bewertung der ermittelten zumindest einen Information über den technischen Zustand der auswechselbaren Komponente berücksichtigt wird.

Wie oben bereits dargelegt, kann durch eine Berücksichtigung einer eindeutigen und individuellen bzw. einzigartigen Identifikationsinformation für jede einzelne auswechselbare Komponente eine Historie ermittelt und abgespeichert werden, in der sämtliche im Laufe eines Produktlebenszyklus ermittelte Informationen enthalten sind.

Gemäß einem weiteren Ausführungsbeispiel der Erfindung weist die Einrichtung zum Ermitteln von zumindest einer Information über den technischen Zustand der auswechselbaren Komponente zumindest eine der folgenden Vorrichtungen auf: (a) Eine Lichtschranke zum Durchführen eines Funktionstests eines beweglichen Bauteils der auswechselbaren Komponente, (b) eine Kamera zum Überprüfen der Position von zumindest einem Bauteil der auswechselbaren Komponente mittels einer der Kamera nach geschalteten Bildauswertung, (c) eine Motorleistungsmessvorrichtung zum Überprüfen der Motorleistung eines Motors der auswechselbaren Komponente, (d) eine Widerstandsmessvorrichtung zum Überprüfen eines elektrischen Widerstandes, insbesondere eines Isolationswiderstandes, der auswechselbaren Komponente, (e) eine Spannungsmessvorrichtung zum Überprüfen einer elektrischen Betriebsspannung der auswechselbaren Komponente, und/oder eine Strommessvorrichtung zum Messen der Stromwerte der auswechselbaren Komponente und/oder zum Messen von Stromwerten von zumindest einem Bauteil der auswechselbaren Komponente.

Bevorzugt weist die beschrieben Messstation zumindest zwei der genanten Vorrichtungen auf, so dass die mit diesen Vorrichtungen ermittelbaren Messergebnisse in geeigneter Weise kombiniert bzw. für die weitere Datenauswertung zusammen berücksichtigt werden können. Je größer die Anzahl der gemeinsam für die weitere Datenauswertung kombinierbaren Messergebnisse ist, desto genauer kann der technische Zustand der auswechselbaren Komponente beschrieben und geeignete Instandhaltungsmaßnahmen angegeben werden.

Gemäß einem weiteren Ausführungsbeispiel der Erfindung weist die Einrichtung zum Aufnehmen der auswechselbaren Komponente einen Anschlag auf, mittels welchem die auswechselbare Komponente räumlich genau an der Messstation positioniert werden kann. Dies hat den Vorteil, dass nach einer genauen Positionierung sämtliche Überprüfungs- und Wartungsfunktionen mit hoher Genauigkeit ausgeführt werden können. Dies gilt insbesondere für eine optische Vermessung von einzelnen ggf. besonders verschleißbehafteten Bauteilen der auswechselbaren Komponente.

Falls es sich bei der auswechselbaren Komponente um eine Bauelement-Zuführvorrichtung handelt, dann kann mit einer Kamera die Position, an der die elektronischen Bauelemente zum Zwecke einer Abholung durch einen Bestückkopf sequentiell bereitgestellt werden, direkt von der Kamera erfasst und durch eine geeignete Bildauswertevorrichtung ausgewertet werden.

Der Anschlag kann auch derart ausgebildet sein, dass verschieden breite Komponenten desselben Typs, beispielsweise unterschiedlich breite Zuführvorrichtungen für elektronische Bauelemente, positionsgenau in der Messstation aufgenommen werden können.

Gemäß einem weiteren Aspekt der Erfindung wird ein Computerlesbares Speichermedium beschrieben, in dem ein Programm zum Instandhalten einer auswechselbaren Komponente einer Bestückvorrichtung zum automatischen Bestücken von Bauelementeträgern mit elektronischen Bauelementen gespeichert ist.
Wenn das Programm von einem Prozessor ausgeführt wird, kann das oben beschriebene Instandhaltungsverfahrens durchgeführt werden.

Gemäß einem weiteren Aspekt der Erfindung wird ein Programm-Element zum Instandhalten einer auswechselbaren Komponente einer Bestückvorrichtung zum automatischen Bestücken von Bauelementeträgern mit elektronischen Bauelementen beschrieben. Wenn das Programm-Element von einem Prozessor ausgeführt wird, kann das oben beschriebene Instandhaltungsverfahrens durchgeführt werden.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
- Figur 1a: zeigt ein Messsystem, welches eine Messstation zum Aufnehmen einer Bauelement-Zuführvorrichtung und einen Computer aufweist, welcher sowohl mit der Messstation als auch mit einer externen Datenbank verbunden ist und welcher ein Instandhaltungsverfahren für die Zuführvorrichtung steuert.
- Figur 1b: zeigt ein von einer Kamera der in Figur 1a dargestellten Messstation aufgenommenes Bild, in dem eine an einer Bauelement-Zuführvorrichtung angebrachte Referenzmarkierung zu erkennen ist.
- Figur 1c: zeigt ein weiteres Kamerabild, in dem ein Zahn eines Transportzahnrades für einen Bauelementgurt zu erkennen ist, welcher Zahn teilweise eine Referenzmarkierung verdeckt.
- Figur 2a: zeigt ein Messsystem, welches eine Messstation für eine Bauelement-Zuführvorrichtung, einen mit der Messstation verbundenen Computer, einen Handscanner zum Erfassen eines an der Bauelement-Zuführvorrichtung angebrachten Strichcodes und einen Etikettendrucker zum Drucken eines Strichcode-Aufklebers.
- Figur 2b: zeigt zwei Messsysteme für jeweils eine Bauelement-Zuführvorrichtung, wobei beide Messsysteme über ein Netzwerk mit einem gemeinsamen Etikettendrucker verbunden sind.
- Figur 3: zeigt Ablaufschema eines Instandhaltungsverfahrens für eine Bauelement-Zuführvorrichtung.
- Figur 4: illustriert die Ermittlung eines Instandhaltungsablaufschemas basierend auf einem innerhalb einerbaumartigen Fehlerstruktur identifizierten Fehler einer Bauelement-Zuführvorrichtung.

An dieser Stelle bleibt anzumerken, dass sich in der Zeichnung die Bezugszeichen von gleichen oder von einander entsprechenden Komponenten lediglich in ihrer ersten Ziffer und/oder durch einen angehängten Buchstaben unterscheiden.

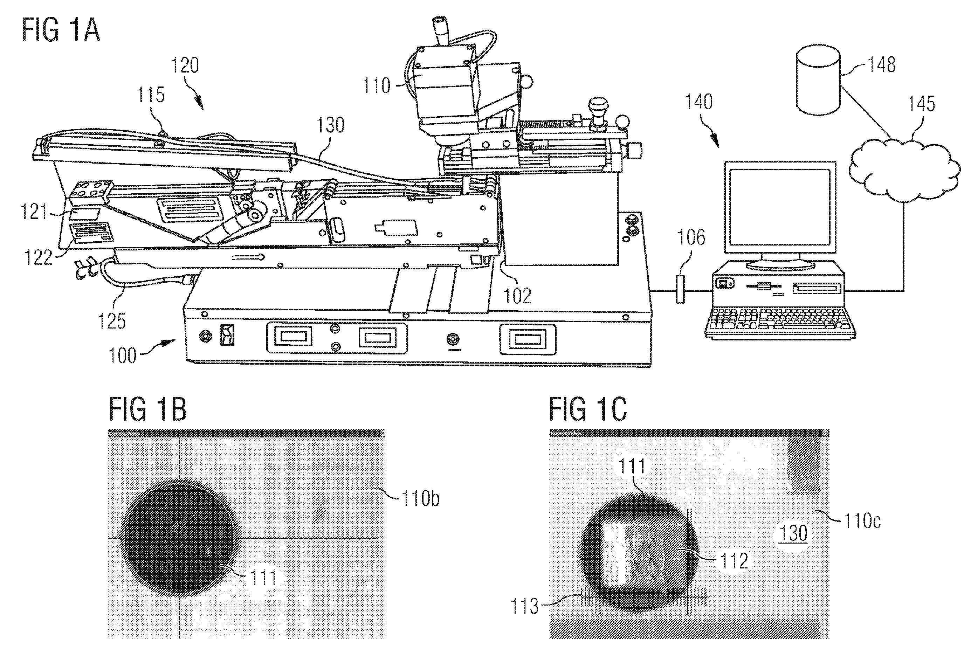

Das in Figur 1a dargestellte Messsystem für eine auswechselbare Komponente 120 einer Bestückvorrichtung weist eine Messstation 100 auf, an welcher die auswechselbare Komponente 120 positionsgenau temporär befestigt werden kann. Gemäß dem hier dargestellten Ausführungsbeispiel ist die auswechselbare Komponente eine Bauelement-Zuführvorrichtung 120, welche häufig auch einfach als Feeder bezeichnet wird. Die positionsgenaue lösbare Befestigung wird durch einen Anschlag 102 gewährleistet. Der Anschlag 102 kann derart ausgebildet sein, dass wählweise verschieden breite Feeder 120 positionsgenau von der Messstation 100 aufgenommen werden können.

Die Messstation 100 kann als eine Art Docking-Station aufgefasst werden, welche zumindest die für einen Testbetrieb der der Zuführvorrichtung 120 erforderlichen Anschlüsse zur Verfügung stellt. Dazu zählt insbesondere eine in Figur 1a nicht dargestellte elektrische Schnittstelle, über welche die Zuführvorrichtung 120 mit der für einen Testbetrieb erforderlichen elektrischen Energie und den notwendigen Ansteuersignalen versorgt wird. Ein entsprechendes Anschlusskabel, welches dem Feeder 120 zugeordnet ist, ist in Figur 1a mit dem Bezugszeichen 125 gekennzeichnet.

Die Messstation 100 weist eine Kamera auf, mittels welcher die genauen Positionen der in bekannter Weise in einem Bauelementgurt 130 an eine Bauelement-Abholposition zum Zwecke der Abholung durch einen Bestückkopf bereit gestellten Bauelemente vermessen werden können. Ebenso können mit der Kamera beispielsweise die Zähne eines Transportzahnrades erfasst werden, welche Zähne mit einer Perforierung des Bauelementegurtes in Eingriff stehen, so dass der Bauelementgurt bei einer Drehung des Transportzahnrades in Richtung der Bauelement-Abholposition gefördert wird. Gemäß dem hier dargestellten Ausführungsbeispiel ist die Kamera derart eingerichtet, dass jeweils der nach oben gerichtete Zahn bzw. Stift des Transportzahnrades mit einer geeigneten optischen Vergrößerung aufgenommen wird, so dass durch eine der Bildaufnahme nachgeschaltete Bildauswerteprozedur die genaue Form des jeweiligen Zahns bzw. Stifts bestimmt werden kann. Da die genaue Form der Zähne bzw. der Stifte direkt mit dem Verschleißzustand des Transportzahnrades zusammen hängt, kann eine geeignete Bildauswertung als Ausgabeparameter eine Maßzahl ausgeben, welche den Verschleiß des Transportzahnrades angibt. Aus diesem Ausgabeparameter können dann nachfolgend geeignete Maßnahmen für die Instandhaltung der Bauelement-Zuführvorrichtung abgeleitet werden. Diese Maßnahmen umfassen beispielsweise die Anweisung an eine Bedienperson, das verschlissene Transportzahnrad sofort oder zu einem definierten späteren Zeitpunkt gegen ein neues Transportzahnrad auszutauschen.

Figur 1b zeigt ein von der Kamera 210 aufgenommenes Bild 110b, welches den Bereich der Bauelement-Abholposition zeigt. Zu erkennen ist eine Referenzmarkierung 111, welche üblicherweise für einen Lernprozess der Zuführvorrichtung 120 im Hinblick auf eine möglichst exakte Bereitstellung von Bauelementen an der Bauelement-Abholposition verwendet wird. Wie aus Figur 1c ersichtlich, welche ebenfalls ein von der Kamera 110 aufgenommenes Kamerabild 110c zeigt, kann die Referenzmarkierung 111 auch dazu verwendet werden, die genaue Form eines Zahns 112 eines Transportrades zu erfassen. Dieser Zahn befindet sich in Figur 1c unmittelbar vor der Referenzmarkierung 111, so dass diese teilweise verdeckt ist. Trotzdem kann durch einen Vergleich mit der genauen Größe und der Form der Referenzmarkierung 111 die Form und die Größe des Zahns 112 genau bestimmt werden. Um die Auswertung von Form und Größe des Zahns 112 zu verbessern, ist gemäß dem hier dargestellten Ausführungsbeispiel eine genau definierte Längenskala in das Kamerabild 110c eingeblendet.

Wie aus Figur 1a ferner ersichtlich, weist die Messstation 100 außerdem eine Motorleistungsmessvorrichtung 115 auf. Mittels der Motorleistungsmessvorrichtung 115 kann die von der Zuführvorrichtung bzw. von dem Transportmechanismus der Zuführvorrichtung maximal aufbringbare Zugkraft gemessen werden, mit der der Bauelementgurt hin zu der Bauelement-Abholposition der Bauelement-Zuführvorrichtung 120 transportiert werden kann. Die Motorleistungsmessvorrichtung 115 kann beispielsweise eine geeignet angebrachte Federwaage aufweisen, deren Federkraft bevorzugt automatisch von der Messstation 100 erfasst werden kann.

Die Messstation 100 weist ferner eine nicht dargestellte Auslesevorrichtung auf, mittels der Daten aus einem Datenspeicher 121 ausgelesen werden können, welcher Datenspeicher 121 der Bauelement-Zuführvorrichtung 120 zugeordnet ist. In dem Datenspeicher 121 können beispielsweise bisher von der Bauelement-Zuführvorrichtung 120 geleistete Arbeitszyklen gespeichert werden. Dabei kann ein Arbeitszyklus beispielsweise der Bereitstellung von einem oder von einer bestimmten Anzahl von elektronischen Bauelementen an der Bauelement-Abholposition entsprechen. Die Information über die bisherige Arbeitsleistung der Zuführvorrichtung 120 kann bei einer Instandhaltungsprozedur durch eine an die Arbeitsleistung angepasste Auswahl von geeigneten Maßnahmen bzw. Arbeitsabläufe bei der Instandhaltung berücksichtigt werden.

Der der Auswahl der geeigneten Instandhaltungsmaßnahmen kann auch eine Identifikationsinformation 122 berücksichtig werden, welche nicht nur den Typ des jeweiligen Feeders 120 sondern exakt dessen Identität innerhalb einer Vielzahl von gleichartigen Feedern kennzeichnet, welche Feeder innerhalb einer gesamten Produktionsstätte für elektronische Baugruppen verwendet werden. Da eine Produktionsstätte ggf. eine Vielzahl von Bestückautomaten aufweisen kann, kann gleichzeitig eine entsprechend hohe Anzahl an Feedern für die verschiedenen Bestückautomaten verwendet werden. Gemäß dem hier dargestellten Ausführungsbeispiel ist die Identifikationsinformation mittels eines Strichcodes 122 realisiert.

Wie aus Figur 1a ferner ersichtlich, weist die Messstation 100 außerdem eine Schnittstelle 106 auf, über welche die Messstation 100 mit einem Computer 140 verbunden werden kann. Gemäß dem hier dargestellten Ausführungsbeispiel ist dieser Computer 140 über ein Netzwerk 145 mit einer Datenbank 148 verbunden. In dieser Datenbank ist eine Vielzahl von verschiedenen spezifischen Maßnahmen gespeichert, welche abhängig von einem Fehler der Zuführvorrichtung 120 im Rahmen einer Instandhaltungsprozedur von einer Bedienperson abzuarbeiten sind. Dabei ist jedem Fehler eindeutig eine spezifische Maßnahme zugeordnet, welche beispielsweise einen Austausch eines bestimmten Verschleiß behafteten Teils der Zuführvorrichtung 120 umfasst. Dabei kann der bei dem Feeder 120 vorliegende Fehler von der Motorleistungsmessvorrichtung 115 und/oder von der Kamera 110 erkannt und von dem Computer 140 identifiziert werden.

Es wird darauf hingewiesen, dass die Datenbank 148 auch in dem Computer integriert sein kann. So können die entsprechenden Daten beispielsweise auf einer Festplatte des Computers 140 gespeichert sein. Ebenso können die entsprechenden Daten auf einem von dem Computer lesbaren mobilen Datenträger wie beispielsweise einer CD- oder einer DVD-ROM gespeichert sein.

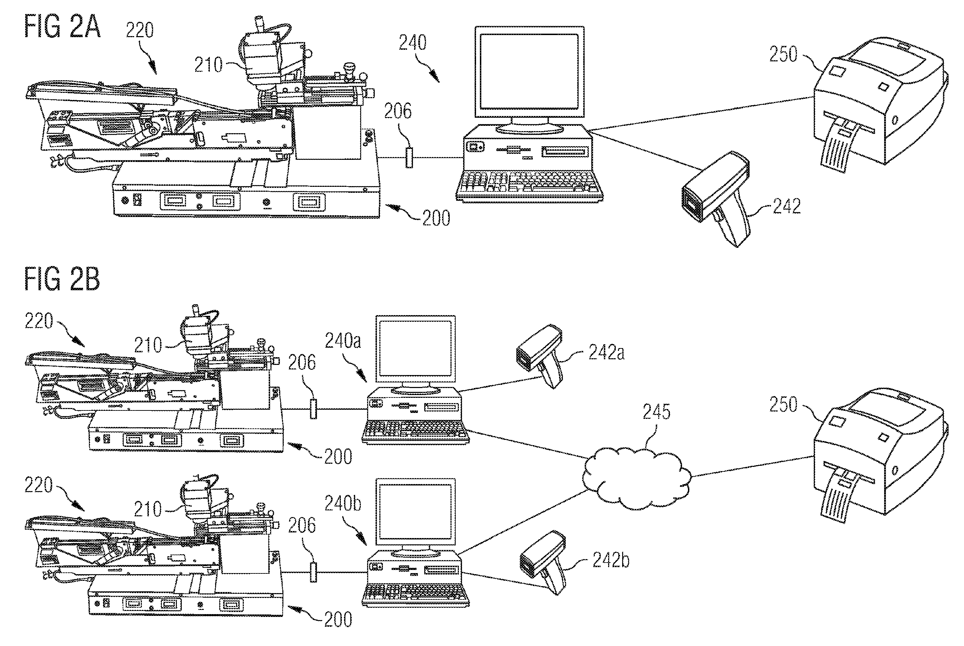

Figur 2a zeigt ein Messsystem, welches eine Messstation 200 zum positionsgenauen Aufnehmen einer Bauelement-Zuführvorrichtung 220 sowie eine Kamera 210 zum optischen Vermessen der Bauelement-Zuführvorrichtung 220 aufweist. Die Messstation 200 ist mit der in Figur 1a dargestellten Messstation 100 identisch, so dass aus Gründen der Übersichtlichkeit die anderen Komponenten der Messstation 200 sowie der Bauelement-Zuführvorrichtung 220 nicht näher bezeichnet sind. Die Messstation 200 ist über eine Schnittstelle 206 mit einem Computer 240 verbunden, welcher ein mittels der Messstation 200 durchzuführenden Messprogramm steuert. Mit dem Messprogramm können Fehler bzw. Fehlfunktionen der Zuführvorrichtung 220 erkannt und an den Computer 240 übermittelt werden. Gemäß dem hier dargestellten Ausführungsbeispiel ist der Computer 240, auf dem eine geeignete Software installiert ist, in der Lage, basierend auf den von der Messstation 200 erfassten und übermittelten Informationen über den technischen Zustand der Zuführvorrichtung 220 den genauen technischen Fehler der Zuführvorrichtung 220 zu identifizieren. Ferner sind in einer nicht dargestellten Datenbank, auf welche der Computer 140 einen Zugriff hat, genaue Anweisungen an eine Bedienperson hinterlegt, welche Maßnahmen für eine optimale Instandhaltung der Zuführvorrichtung 220 durchzuführen sind.

Das in Figur 2a dargestellte Messsystem weist ferner einen Handscanner 242 und einen Drucker250 auf, welche beide mit dem Computer 240 verbunden sind. Der Handscanner 242 kann dabei dazu verwendet werden, Identifikationsinformationen von Zuführvorrichtungen 220 einzulesen, welche von der Messstation 200 aufgenommen sind. Wie oben im Zusammenhang mit Figur 1a bereits dargelegt, können diese Identifikationsinformationen dazu verwendet werden, die für jede einzelne Zuführvorrichtung optimalen Instandhaltungsmaßnahmen auszuwählen. Der Drucker 250, welcher beispielsweise über eine gewöhnliche USB-Schnittstelle mit dem Computer 240 verbunden ist, kann dazu verwendet werden, für Zuführvorrichtungen 220, welche noch nicht mit einer Identifikationsinformation versehen sind, eine derartige Identifikationsinformation zu erzeugen. Gemäß dem hier dargestellten Ausführungsbeispiel können mit dem Drucker 250 Strichcodes auf jeweils einen Aufkleber aufgebracht werden, welcher auf einfache Weise als geeignete Identifikationsinformation an der Zuführvorrichtung angebracht werden kann.

Figur 2b zeigt ein Messsysteme, welches zwei Messstationen 200 aufweist, welche jeweils auf die gleiche Weise wie die in Figur 2a dargestellte Messstation aufgebaut sind. Jede Messstation 200 ist über eine Schnittstelle 206 mit einem Computer 240a bzw. 240b verbunden. Dem Computer 240a ist ein Handscanner 242a zugeordnet, dem Computer 240b ist ein Handscanner 242b zugeordnet. Mit den Handscannern 242a und 242b können die Identifikationsinformationen von Zuführvorrichtungen 220 eingelesen werden.

Die beiden Computer 240a und 240b sind über ein Netzwerk 245 mit einem gemeinsamen Drucker 250 verbunden, welcher zum Aufbringen von Strichcodes auf jeweils einen Aufkleber eingerichtet ist. Wie oben bereits ausgeführt, können diese Strichcodes als Identifikationsinformationen für Bauelement-Zuführvorrichtungen verwendet werden.

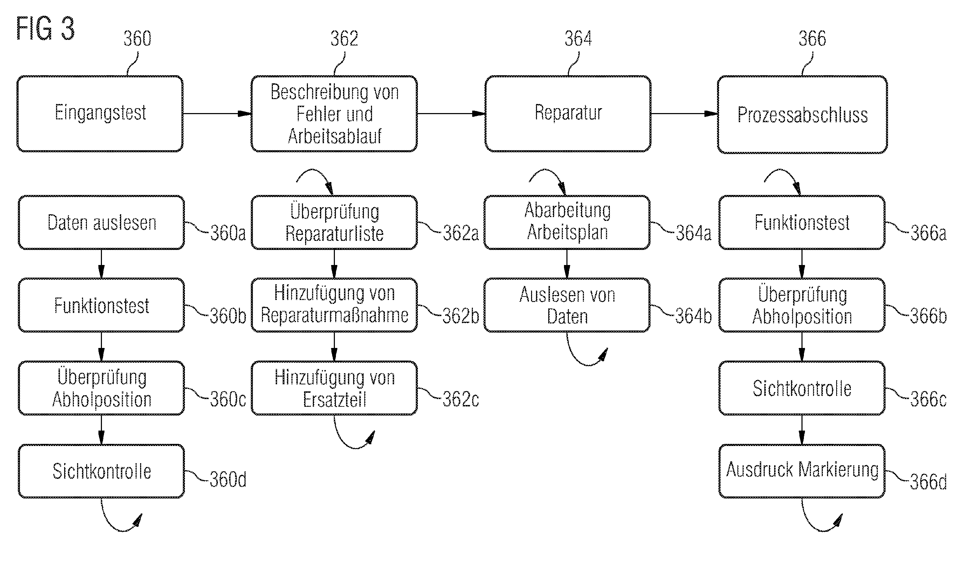

Figur 3 zeigt ein zeigt Ablaufschema eines Instandhaltungsverfahrens für eine Bauelement-Zuführvorrichtung. Das Instandhaltungsverfahren kann dabei grob in vier Blöcke unterteilt werden, welche mit den Bezugszeichen 360, 362, 364 und 366 gekennzeichnet sind.

Das beschriebene Instandhaltungsverfahren beginnt mit einem Eingangstest 360, welcher ein Einlesen von Daten 360a umfasst. Diese Daten sind der zu wartenden bzw. der Instand zu haltenden Bauelement-Zuführvorrichtung zugeordnet. Diese Daten könne beispielsweise die oben beschriebene Identifikationsinformation oder eine bisher von der Bauelement-Zuführvorrichtung vollbrachte Arbeitsleistung sein. Ferner können die Daten auch die bisher von der Bauelement-Zuführvorrichtung geleisteten Betriebsstunden sein. Der Eingangstest 360 umfasst ferner einen Funktionstest 360b der Bauelement-Zuführvorrichtung. Dabei wird insbesondere die genaue Lage der Abholposition überprüft, an der die elektronischen Bauelemente bereitgestellt werden. Die Überprüfung der Abholposition der elektronischen Bauelemente ist mit dem Bezugszeichen 360c gekennzeichnet. Außerdem umfasst der Eingangstest 360 noch eine Sichtkontrolle 360d der Bauelement-Zuführvorrichtung. Dabei können insbesondere mechanische Beschädigungen der Bauelement-Zuführvorrichtung erkannt werden.

Nach dem Eingangstest 360 folgt eine Fehlerbeschreibung und eine Beschreibung eines geeigneten Arbeitsablaufs für die Instandhaltung der auswechselbaren Komponente. Diese Beschreibung von Fehler und Arbeitsablauf ist mit dem Bezugszeichen 362 gekennzeichnet. Im Rahmen dieser Beschreibung von Fehler und Arbeitsablauf erfolgt unter Anderem eine Überprüfung einer Reparaturliste 362a, eine ggf. erforderliche Hinzufügung von Reparaturmaßnahmen 362b für eine möglichst optimale Instandhaltung bzw. Reparatur der Bauelement-Zuführvorrichtung, und ggf. eine Hinzufügung eines Ersatzteiles 362c zu bereits bereitgestellten Ersatzteilen, welche für die bevorstehende Instandhaltung bzw. Reparatur benötigt werden, die von einer Bedienperson ausgeführt wird.

Das beschriebene Instandhaltungsverfahren wird mit der eigentlichen Reparatur bzw. Instandhaltung der Bauelement-Zuführvorrichtung fortgesetzt. Dieser Block ist in Figur 3 mit dem Bezugszeichen 364 gekennzeichnet. Die Reparatur 364 umfasst eine genaue Abarbeitung eines Arbeitsplanes 364a und ggf. ein Auslesen von Daten 364b, mit denen die erfolgreiche Abarbeitung des Arbeitsplanes dokumentiert wird.

Am Ende des beschriebenen Instandhaltungsverfahrens erfolgt ein Prozessabschluss 366. Gemäß dem hier dargestellten Ausführungsbeispiel umfasst der Prozessabschluss 366 einen erneuten Funktionstest 366a, bei dem insbesondere die genaue Lage der Bauelement-Abholposition überprüft wird. Die Überprüfung der Abholposition ist mit dem Bezugszeichen 366b gekennzeichnet. Ferner umfasst der Prozessabschluss 360 eine erneute Sichtkontrolle 366c sowie ggf. einen Ausdruck einer Identitätsinformation in Form einer geeigneten Markierung 366d, so wie es zuvor beispielsweise anhand von Figur 2a beschrieben wurde.

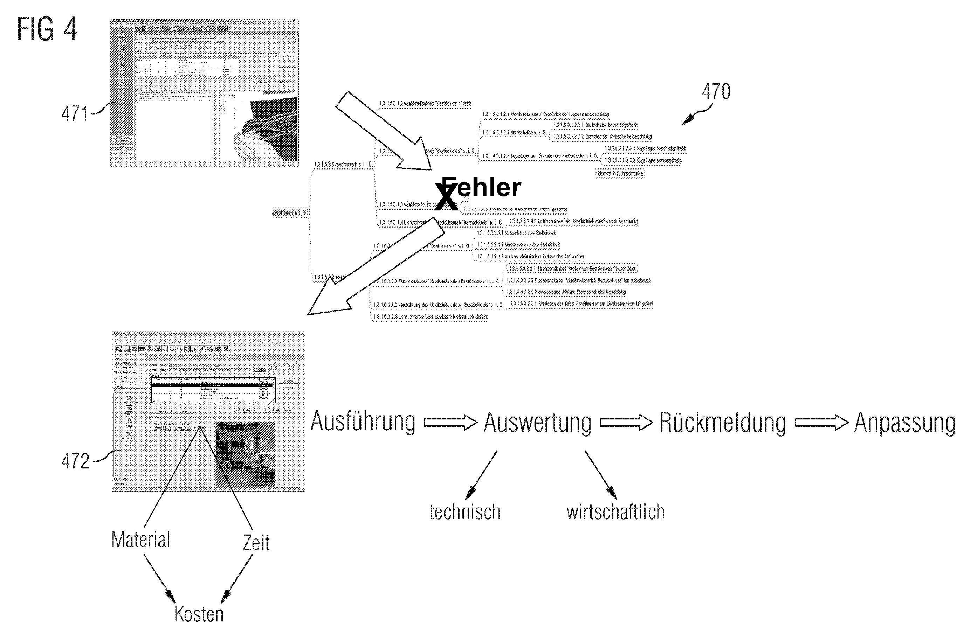

Figur 4 illustriert eine Software-unterstützte Ermittlung eines optimalen Ablaufschemas für eine Instandhaltung einer Bauelement-Zuführvorrichtung. Nach dem Ermitteln des technischen Zustands der Bauelement-Zuführvorrichtung unter Verwendung der insbesondere in der Figur 1a dargestellten Messstation wird von der Software der aktuell vorliegende Fehler der Bauelement-Zuführvorrichtung identifiziert und mittels einer Bildschirmmaske 471 einer Bedienperson angezeigt.

Ferner wird von der Software der identifizierte Fehler in einer Datenbank gesucht, in der für eine Vielzahl von verschiedenen Fehlern jeweils eindeutig ein genauer Maßnahmenkatalog zur Durchführung einer optimalen Instandhaltung bzw. Reparatur enthalten ist. Gemäß dem beschriebenen Ausführungsbeispiel sind eine Vielzahl von möglichen Fehlern in der Datenbank strukturiert in Form einer hierarchischen Fehlerbaumstruktur 470 gelistet. Dabei ist für jeden Fehler der jeweils optimale Maßnahmenkatalog beispielsweise in Form einer Ziffernfolge hinerlegt, welche eine geeignete Codierung darstellt.

Der jeweils optimale Maßnahmenkatalog für die bevor stehende Instandhaltung wird der ausführenden Bedienperson in einer Bildschirmmaske 472 angezeigt. Die Bildschirmmaske 472 beschreibt dabei den genauen Arbeitsablauf für die effiziente und effektive Beseitigung des zuvor identifizierten Fehlers.

Gemäß dem hier dargestellten Ausführungsbeispiel enthält die Bildschirmmaske 472 außerdem Informationen über das benötigte Material und den zu erwartenden Zeitaufwand für die Instandhaltung der Bauelement-Zuführvorrichtung. Da diese beiden Parameter maßgeblich den Kostenaufwand für die Instandhaltung bestimmen, kann auf einfache Weise ermittelt werden, ob eine Reparatur der Bauelement-Zuführvorrichtung aus wirtschaftlichen Gesichtspunkten überhaupt noch rentabel ist. Ferner können diese Parameter für ein allgemeines Management der Instandhaltung von einer Vielzahl von Bauelement-Zuführvorrichtungen verwendet werden, welche Zuführvorrichtungen beispielsweise innerhalb einer Produktionsstätte für verschiedene Bestückvorrichtungen verwendet werden.

Ferner kann auch nach einer Ausführung der Instandhaltung eine Auswertung erfolgen, die einem Betreiber einer Bestücklinie wertvolle technische und wertvolle wirtschaftliche Informationen an die Hand geben kann. Diese Informationen können selbstverständlich durch geeignete graphische Darstellungen ausgegeben werden. Zu den technischen Informationen zählt beispielsweise eine Prognose für die Zeitdauer, innerhalb der ein Ausfall der Zuführvorrichtung zu erarten ist. Zu den wirtschaftlichen Informationen zählt beispielsweise, dass nach einem Ausfall einer bestimmten Komponente der Zuführvorrichtung eine Reparatur vermutlich nicht mehr rentabel ist.

Nach der Auswertung kann optional eine Rückmeldung erfolgen, mit der eine handelnde Bedienperson Informationen über zumindest die wichtigsten Aspekte der Auswertung zur Verfügung gestellt wird. Auf diese Weise kann sichergestellt werden, dass die Bedienperson auch tatsächlich Kenntnis von diesen Informationen erhält.

Ferner können die im Rahmen der Auswertung gewonnenen Erkenntnisse auch zur Anpassung des Verfahrens zum Instandhalten von Bauelement-Zuführvorrichtungen verwendet werden. Dabei kann beispielsweise der Wartungsabstand verändert und so die Instandhaltung der Zuführvorrichtungen deutlich effektiver gestaltet werden. Falls sich herausstellt, dass nur geringe Wartungsarbeiten notwendig waren und sich die Zuführvorrichtung auch vor dem durchgeführten Instandhaltungsverfahren bereits in einem guten technischen Zustand befunden hat, dann kann beispielsweise der Wartungsabstand zwischen zwei aufeinanderfolgenden Instandhaltungsprozeduren für ein und dieselbe Zuführvorrichtung verlängert werden. Entsprechend kann der Wartungsabstand verkürzt werden, wenn weitreichende Instandhaltungsmaßnahmen erforderlich waren und/oder wenn sich die Zuführvorrichtung zuvor in einem technisch sehr schlechten Zustand befunden hat. Außerdem können ggf. Eingriffsgrenzen verändert werden, mit denen Grenzwerte für bestimmte Messparameter definiert sind. Eine Überschreitung dieser Grenzwerte hat dann gemäß dem in dieser Anmeldung beschriebenen Instandhaltungsverfahren einen entsprechenden Wartungseingriff zur Folge.

Es wird darauf hingewiesen, dass durch die beschriebene Anpassung ein geschlossener Regelkreis zum Instandhalten von Bauelement-Zuführvorrichtungen geschaffen wird, so dass stets eine sowohl aus technischer als auch aus wirtschaftlicher Sicht effektive Instandhaltung der Zuführvorrichtungen gewährleistet werden kann.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Messstation
- 102: Anschlag
- 106: Schnittstelle
- 110: Kamera
- 110b: Kamerabild
- 110c: Kamerabild
- 111: Referenzmarkierung / Teachmarke
- 112: Zahn von Transportrad / Stift von Transportrad
- 113: eingeblendete Längenskala
- 115: Motorleistungsmessvorrichtung
- 120: auswechselbare Komponente / Bauelement-Zuführvorrichtung / Feeder
- 121: Datenspeicher
- 122: Identifikationsinformation / Strichcode
- 125: Anschlusskabel
- 130: Bauelementgurt
- 140: Datenverarbeitungseinrichtung / Computer
- 145: Netzwerk
- 148: Datenbank

- 200: Messstation
- 206: Schnittstelle
- 210: Kamera
- 220: auswechselbare Komponente / Bauelement-Zuführvorrichtung / Feeder
- 240: Datenverarbeitungseinrichtung / Computer
- 240a: Datenverarbeitungseinrichtung / Computer
- 240b: Datenverarbeitungseinrichtung / Computer
- 242: Handscanner
- 242a: Handscanner
- 242b: Handscanner
- 245: Netzwerk
- 250: Drucker
- 360: Eingangstest
- 360a: Daten auslesen
- 360b: Funktionstest
- 360c: Überprüfung Abholposition
- 360d: Sichtkontrolle
- 362: Beschreibung von Fehler und Arbeitsablauf
- 362a: Überprüfung Reparaturliste
- 362b: Hinzufügung von Reparaturmaßnahme
- 362c: Hinzufügung von Ersatzteil
- 364: Reparatur
- 364a: Abarbeitung Arbeitsplan
- 354b: Auslesen von Daten
- 366: Prozessabschluss
- 366a: Funktionstest
- 366b: Überprüfung Abholposition
- 366c: Sichtkontrolle
- 366d: Ausdruck Markierung

- 470: Fehlerbaumstruktur
- 471: Bildschirmmaske: Fehlerbeschreibung
- 472: Bildschirmmaske: Arbeitsablauf für Fehlerbeseitigung

## Patentansprüche

1. Verfahren zum Instandhalten einer auswechselbaren Komponente (120, 220) einer Bestückvorrichtung zum automatischen Bestücken von Bauelementeträgern mit elektronischen Bauelementen, das Verfahren aufweisend
• Ermitteln von zumindest einer Information über den technischen Zustand der auswechselbaren Komponente (120, 220),
• Identifizieren eines Fehlers der auswechselbaren Komponente (120, 220) basierend auf der zumindest einen ermittelten Information, und
• Extrahieren von zumindest einer spezifischen Maßnahme zum Instandhalten der auswechselbaren Komponente (120, 220) basierend auf dem Fehler aus einer Datenbank (148), in welcher mehrere verschiedene spezifische Maßnahmen gespeichert sind, wobei jedem Fehler eindeutig zumindest eine spezifische Maßnahme zugeordnet ist.

2. Verfahren nach Anspruch 1, wobei
die zumindest eine Information durch Auslesen von Daten aus einem der auswechselbaren Komponente (120, 220) zugeordneten Datenspeicher (121) ermittelt wird.

3. Verfahren nach einem der Ansprüche 1 bis 2, wobei
die zumindest eine Information durch zumindest eine spezifische Messung an der auswechselbaren Komponente (120, 220) ermittelt wird.

4. Verfahren nach Anspruch 3, wobei
die zumindest eine spezifische Messung aufweist
• einen Funktionstest eines beweglichen Bauteils der auswechselbaren Komponente (120, 220) mittels einer Lichtschranke,
• eine Positionsüberprüfung von zumindest einem Bauteil der auswechselbaren Komponente (120, 220) mittels einer Kamera (110, 210) und einer der Kamera (110, 210) nach geschalteten Bildauswertung,
• eine Überprüfung der Motorleistung eines Motors der auswechselbaren Komponente (120, 220),
• eine Messung eines Isolationswiderstandes und/oder
• eine Messung der Stromwerte der auswechselbaren Komponente und/oder eine Messung von Stromwerten von zumindest einem Bauteil der auswechselbaren Komponente.

5. Verfahren nach einem der Ansprüche 3 bis 4, zusätzlich aufweisend
• Ermitteln von zumindest einem Prozessfähigkeitskennwert für die auswechselbare Komponente (120, 220) basierend auf einem Ergebnis der zumindest einen spezifischen Messung.

6. Verfahren nach einem der Ansprüche 1 bis 5, zusätzlich aufweisend
• Bestimmen von zukünftig zu erwartenden Fehlern bezüglich des technischen Zustandes der auswechselbaren Komponente (120, 220) basierend auf der zumindest einen ermittelten Information.

7. Verfahren nach einem der Ansprüche 1 bis 6, zusätzlich aufweisend
• Verwenden einer eindeutigen Identitätsinformation (122) für die auswechselbare Komponente (120, 220) und
• Aufzeichnen der ermittelten Informationen über den technischen Zustand der auswechselbaren Komponente (120, 220) zusammen mit der eindeutigen Identitätsinformation (122).

8. Verfahren nach einem der Ansprüche 1 bis 7, zusätzlich aufweisend
• Anweisen einer Bedienperson zum Durchführen der zumindest einen spezifischen Maßnahme zum Instandhalten der auswechselbaren Komponente (120, 220) und
• Überprüfen, ob die zumindest eine spezifische Maßnahme auch tatsächlich ausgeführt wurde.

9. Messsystem für eine auswechselbare Komponente (120, 220) einer Bestückvorrichtung zum automatischen Bestücken von Bauelementeträgern mit elektronischen Bauelementen, das Messsystem aufweisend
• eine Messstation (100, 200) zum Aufnehmen der auswechselbaren Komponente (120, 220) und zum Ermitteln von zumindest einer Information über den technischen Zustand der auswechselbaren Komponente (120, 220), und
• eine Datenverarbeitungseinrichtung (140, 240), welche über eine Schnittstelle (106, 206), die zum Übertragen der zumindest einen ermittelten Information eingerichtet ist, mit der Messstation (100, 200) gekoppelt ist,
wobei die Datenverarbeitungseinrichtung (140, 240) derart eingerichtet ist, dass
- basierend auf der zumindest einen ermittelten Information ein Fehler der auswechselbaren Komponente (120, 220) identifizierbar ist und dass
- basierend auf dem Fehler aus einer Datenbank (148) zumindest eine spezifische Maßnahme zum Instandhalten der auswechselbaren Komponente (120, 220) extrahiert wird, wobei in der Datenbank (148) mehrere verschiedene spezifische Maßnahmen gespeichert sind und wobei
jedem Fehler eindeutig eine spezifische Maßnahme zugeordnet ist.

10. Messstation für eine auswechselbare Komponente (120, 220) einer Bestückvorrichtung zum automatischen Bestücken von Bauelementeträgern mit elektronischen Bauelementen, die Messstation (100, 200) aufweisend
• eine Einrichtung zum Aufnehmen der auswechselbaren Komponente (120, 220),
• eine Einrichtung zum Ermitteln von zumindest einer Information über den technischen Zustand der auswechselbaren Komponente (120, 220) und
• eine Schnittstelle (106, 206) zum Anschließen der Messstation an eine Datenverarbeitungseinrichtung (140, 240), wobei die Schnittstelle (106, 206) derart eingerichtet ist, dass die zumindest eine Information über den technischen Zustand der auswechselbaren Komponente (120, 220) an die Datenverarbeitungseinrichtung (140, 240) transferierbar ist,
wobei die Messstation (100, 200) derart eingerichtet ist, dass in Verbindung mit der Datenverarbeitungsvorrichtung (140, 240) das Verfahren nach einem der Ansprüche 1 bis 8 ausführbar ist.

11. Messstation nach Anspruch 10, zusätzlich aufweisend
• eine Einrichtung zum Identifizieren der auswechselbaren Komponente (120, 220).

12. Messstation nach einem der Ansprüche 10 bis 11, wobei die Einrichtung zum Ermitteln von zumindest einer Information über den technischen Zustand der auswechselbaren Komponente (120, 220) zumindest eine der folgenden Vorrichtungen aufweist:
• eine Lichtschranke zum Durchführen eines Funktionstests eines beweglichen Bauteils der auswechselbaren Komponente (120, 220),
• eine Kamera (110, 210) zum Überprüfen der Position von zumindest einem Bauteil der auswechselbaren Komponente (120, 220) mittels einer der Kamera (110, 210) nach geschalteten Bildauswertung,
• eine Motorleistungsmessvorrichtung (115) zum Überprüfen der Motorleistung eines Motors der auswechselbaren Komponente (120, 220),
• eine Widerstandsmessvorrichtung zum Überprüfen eines elektrischen Widerstandes, insbesondere eines Isolationswiderstandes, der auswechselbaren Komponente (120, 220), und/oder
• eine Spannungsmessvorrichtung zum Überprüfen einer elektrischen Betriebsspannung der auswechselbaren Komponente (120, 220)
• eine Strommessvorrichtung zum Messen der Stromwerte der auswechselbaren Komponente und/oder zum Messen von Stromwerten von zumindest einem Bauteil der auswechselbaren Komponente.

13. Messstation nach einem der Ansprüche 10 bis 12, wobei die Einrichtung zum Aufnehmen der auswechselbaren Komponente (120, 220) einen Anschlag (102) aufweist, mittels welchem die auswechselbare Komponente (120, 220) räumlich genau an der Messstation (100, 200) positioniert werden kann.

14. Computerlesbares Speichermedium, in dem ein Programm zum Instandhalten einer auswechselbaren Komponente (120, 220) einer Bestückvorrichtung zum automatischen Bestücken von Bauelementeträgern mit elektronischen Bauelementen gespeichert ist, das, wenn es von einem Prozessor ausgeführt wird, zum Durchführen des Verfahrens nach einem der Ansprüche 1 bis 8 eingerichtet ist.

15. Programm-Element zum Instandhalten einer auswechselbaren Komponente (120, 220) einer Bestückvorrichtung zum automatischen Bestücken von Bauelementeträgern mit elektronischen Bauelementen, das Programm-Element, wenn es von einem Prozessor ausgeführt wird, zum Durchführen des Verfahrens nach einem der Ansprüche 1 bis 8 eingerichtet ist.
